# EUROPEAN PATENT APPLICATION

(11) **EP 4 270 235 A1**
(43) Date of publication of application: **01.11.2023**
(21) Application number: 21910374.4
(22) Date of filing: 10.12.2021
(51) Int. Cl.: G06F 30/27, G06K 19/067

(54) **TAG GROUP, DESIGN DEVICE, DESIGN METHOD, LEARNED MODEL, AND IDENTIFICATION DEVICE**

(30) Priority: 22.12.2020 JP 2020212376
(71) Applicant: KONICA MINOLTA, INC., Tokyo 100-7015 (JP)
(72) Inventor: ENOKIDA, Ippei, Tokyo 100-7015 (JP); OSAWA, Ko, Tokyo 100-7015 (JP); SEKINE, Koujirou, Tokyo 100-7015 (JP); ISHIWATA, Takumi, Tokyo 100-7015 (JP); HAKII, Takeshi, Tokyo 100-7015 (JP)
(74) Representative: Hoffmann Eitle
(86) International application number: PCT/JP2021/045485
(87) International publication number: WO 2022/138225

(57) **Abstract**

A plurality of tags Tag included in a tag group 10 each have a conductor arranged in a selective region thereof, and a corresponding one of spectrum information items on electromagnetic waves different from each other. In the plurality of tags Tag included in the tag group 10, an objective function set for the spectrum information items on the electromagnetic waves has converged.

## Description

### Technical Field

The present invention relates to a tag group, a design apparatus, a design method, a learned model, and an identification apparatus.

### Background Art

At present, a radio frequency identification (RFID) is being developed to promote smart society. In particular, since an integrated circuit (IC) chip is not necessary, which is advantageous in terms of cost, expectations for a chipless RFID are increasing (e.g., Non Patent Literatures 1 and 2).

In the chipless RFID, for example, a tag is identified by using a difference in resonance frequency derived from a difference in design of the tag.

### Citation List

### Non Patent Literature

Non Patent Literature 1: D.Betancourt; M.Barahona; K.Haase; G.Schmidt; A.Hubler; F.Ellinger, "Design of Printed Chipless-RFID Tags With QR-Code Appearance Based on Genetic Algorithm" IEEE Transactions on Antennas and Propagation, 2017, 65, 2190
Non Patent Literature 2: Borgese,M., Costa,F., Genovesi,S. et al. Optimal Design of Miniaturized Reflecting Metasurfaces for Ultra-Wideband and Angularly Stable Polarization Conversion. Sci Rep 8, 7651 (2018).

### Summary of Invention

### Technical Problem

In the chipless RFID, a tag may be identified using a peak of an electromagnetic wave spectrum. However, in an identification method depending on only the peak of the electromagnetic wave spectrum, it is difficult to increase variations, and it is difficult to increase the number of identifiable tags. For example, although it is anticipated that there is a possibility that more types of tags can be identified using not only peaks of a spectrum but also the entire spectral shape by using an artificial intelligence (AI) technology, a method for producing a tag suitable for identification (classification) using AI has not been established.

The present invention has been made in view of the above circumstances, and an object thereof is to provide a tag group, a design apparatus, a design method, a learned model, and an identification apparatus that are suitable for identification of tags using AI.

### Solution to Problem

The above-described object of the present invention is achieved by the following means.
(1) A tag group including a plurality of tags each having a conductor arranged in a selective region thereof and having a corresponding one of spectrum information items on electromagnetic waves different from each other, wherein an objective function set for the spectrum information items on the electromagnetic waves has converged in the plurality of tags included in the tag group.
(2) The tag group according to (1), wherein the objective function has converged by optimizing arrangement of the conductors by an on/off method of topology optimization.
(3) The tag group according to (1) or (2), wherein the objective function has converged by being searched for using evolutionary computation.
(4) The tag group according to any one of (1) to (3), wherein the objective function is a sum of an average value and a minimum value of differences between the spectrum information items on the electromagnetic waves of the plurality of tags.
(5) The tag group according to any one of (1) to (4), wherein the conductor of each of the plurality of tags is arranged so as to have an axis of rotational symmetry.
(6) The tag group according to any one of (1) to (5), wherein the conductor of each of the plurality of tags is constituted by a combination of a plurality of quadrangular conductors.
(7) The tag group according to (6), wherein the plurality of quadrangular conductors are processed such that the plurality of quadrangular conductors are not in contact with each other at respective corners.
(8) The tag group according to any one of (1) to (7), wherein each of the plurality of tags includes the conductor and a dielectric.
(9) The tag group according to any one of (1) to (8), wherein the spectrum information items on the electromagnetic waves are spectrum information items on electromagnetic waves reflected from the plurality of tags or spectrum information items on electromagnetic waves having passed through the plurality of tags.
(10) A design apparatus including: a design unit that designs a plurality of tags each having a conductor arranged in a selective region thereof; an acquisition unit that acquires a spectrum information item on an electromagnetic wave of each of the plurality of tags designed by the design unit; and a decision unit that decides a tag group including a predetermined number of tags from among the plurality of tags, based on an objective function set for the spectrum information items on the electromagnetic waves acquired by the acquisition unit.
(11) The design apparatus according to (10), further including: a determination unit that determines whether the objective function has converged for the tag group decided by the decision unit; and an output unit that outputs the tag group for which the determination unit has determined that the objective function has converged.
(12) A design method including: designing a plurality of tags each having a conductor arranged in a selective region thereof; acquiring a spectrum information item on an electromagnetic wave of each of the plurality of tags; and deciding a tag group including a predetermined number of tags from among the plurality of tags, based on an objective function set for the spectrum information items on the electromagnetic waves.
(13) A learned model that has been machine-learned in advance using, as training data, a spectrum information item on an electromagnetic wave of each of a plurality of tags constituting a tag group and an identification information item associated with each of the plurality of tags, wherein an objective function set for the spectrum information items on the electromagnetic waves has converged in the plurality of tags included in the tag group.
(14) An identification apparatus that identifies a predetermined tag by inputting a spectrum information item on an electromagnetic wave of the predetermined tag into the learned model according to (13).

### Advantageous Effects of Invention

According to the tag group, the design apparatus, the design method, the learned model, and the identification apparatus of the present invention, the objective function set for the spectrum information items on the electromagnetic waves has converged in the plurality of tags included in the tag group. This facilitates identification of the tag using AI. Therefore, the tag group, the design apparatus, the design method, the learned model, and the identification apparatus can be suitably used for the identification of the tag using AI.

### Brief Description of Drawings

Fig. 1 is a diagram illustrating a schematic configuration of a management system according to an embodiment of the present invention.
Figs. 2A to 2E each are a block diagram illustrating an example of a planar configuration of each of tags constituting a tag group illustrated in Fig. 1.
Fig. 3 is a plan view schematically illustrating, in an enlarged manner, a part of the tags illustrated in Figs. 2A to 2E.
Fig. 4 is a cross-sectional view schematically illustrating, in an enlarged manner, a part of the tags illustrated in Figs. 2A to 2E.
Fig. 5 is a view illustrating another example of the cross-sectional view of the tag illustrated in Fig. 4.
Figs. 6A to 6E are diagrams illustrating examples of spectra of electromagnetic waves obtained from the tags illustrated in Figs. 2A to 2E, respectively.
Fig. 7 is a block diagram illustrating an example of a configuration of a design apparatus that designs each tag of the tag group illustrated in Fig. 1.
Fig. 8 is a block diagram illustrating an example of a functional configuration of the design apparatus illustrated in Fig. 7.
Fig. 9 is a flowchart illustrating a procedure of processing executed in the design apparatus illustrated in Fig. 7.
Fig. 10 is a diagram illustrating a change of an objective function in the tag group decided in step S 104 illustrated in Fig. 9.
Figs. 11A to 11E are diagrams for describing an example of processing of step S106 illustrated in Fig. 9.

### Description of Embodiments

An embodiment of the present invention will be described hereinafter with reference to the attached drawings. Note that in the description of the drawings, the same components are denoted by the same reference numerals, and redundant description will be omitted. In addition, dimensional ratios in the drawings are exaggerated for convenience of explanation and may be different from actual ratios.

### [Management system]

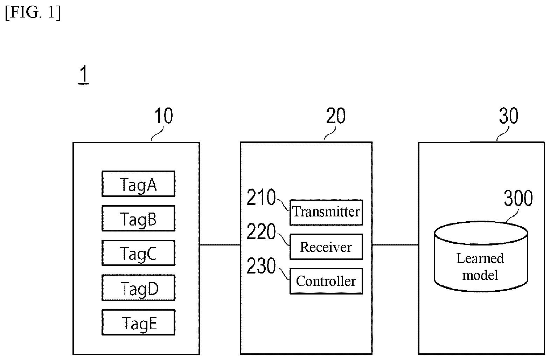

Fig. 1 illustrates a schematic configuration of a management system 1 according to an embodiment of the present invention. The management system 1 includes a tag group 10, a reader 20, and an identification apparatus 30. The tag group 10 includes a plurality of tags (TagA, TagB, TagC, TagD, and TagE, hereinafter simply referred to as Tag when they are not distinguished from each other), and each of the Tags is attached to an article or the like to perform article management. The reader 20 transmits an electromagnetic wave to the Tag and receives, for example, an electromagnetic wave reflected from the Tag. Thus, the reader 20 acquires a spectrum information item on the electromagnetic wave of the Tag attached to the article or the like. The identification apparatus 30 identifies the Tag based on the spectrum information item on the electromagnetic wave acquired by the reader 20. The identification apparatus 30 identifies the Tag by using AI (machine learning). Specifically, the identification apparatus 30 identifies the tag by using a learned model 300.

### (Tag group)

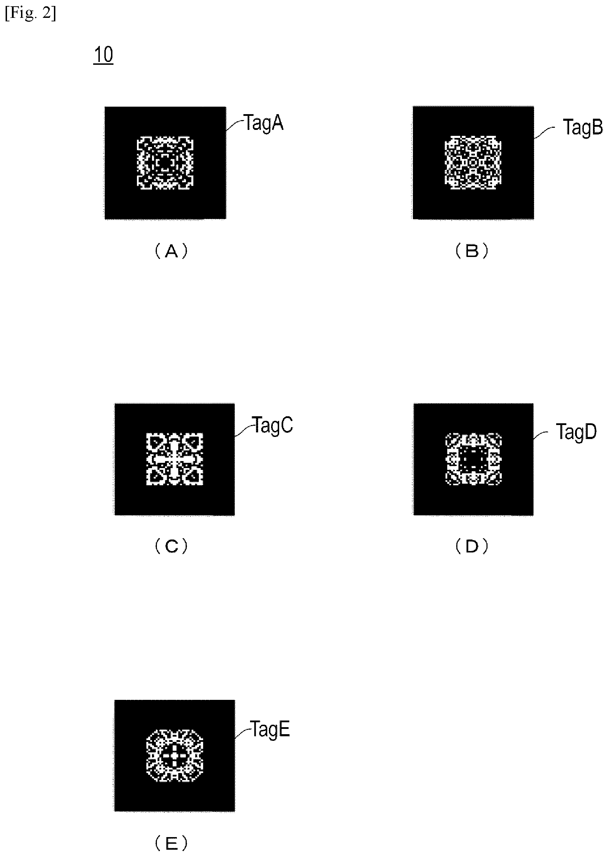

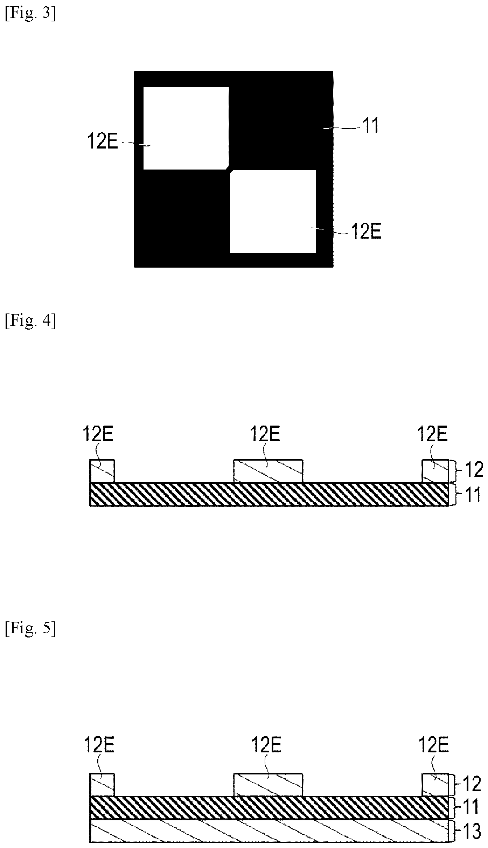

Figs. 2(A) to 2(E) respectively illustrate examples of planar configurations of the TagA, the TagB, the TagC, the TagD, and the TagE of the tag group 10. Figs. 3 and 4 are respectively a plan view and a cross-sectional view illustrating, in an enlarged manner, a part of the Tag.

The tag group 10 includes, for example, five Tags (TagA, TagB, TagC, TagD, and TagE) (Figs. 2(A) to 2(E)). The planar shape of the Tag is, for example, a quadrangular shape such as a square. The planar shape of the Tag is, for example, a square having a side length of 30 mm. The Tag has, for example, a laminated structure of a base material 11 and a conductor layer 12 (Fig. 4).

The base material 11 is provided, for example, over the entire surface of the Tag. The planar shape of the base material 11 is, for example, a quadrangular shape such as a square. The planar shape of the base material 11 is, for example, a square having a side length of 30 mm. The base material 11 is formed of, for example, a dielectric such as paper or a resin material. As the base material 11, for example, a dielectric having a relative dielectric constant of 1.5 can be used.

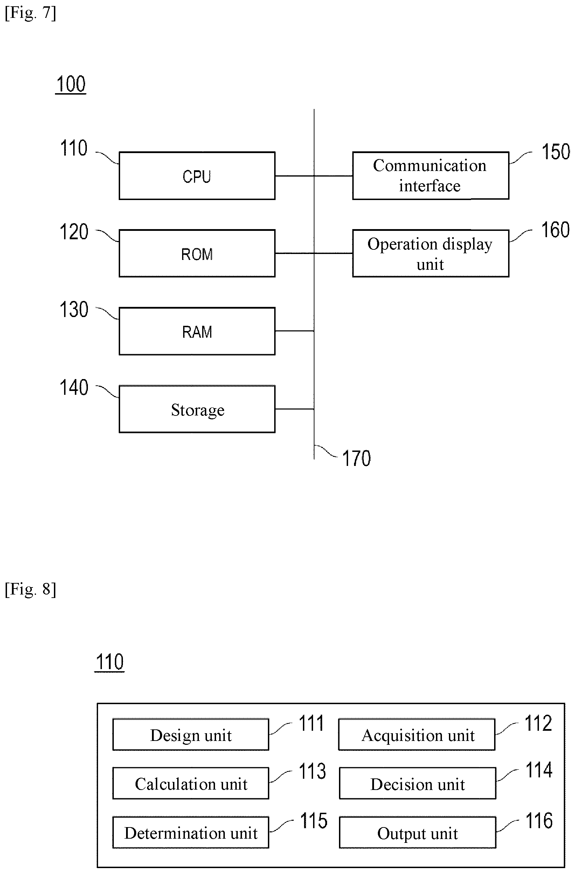

The conductor layer 12 has, for example, a plurality of elements 12E (Figs. 3 and 4), and the plurality of elements 12E are provided in selective regions on the base material 11. In the present embodiment, the arrangement of elements 12E in each Tag constituting the tag group 10 is designed by a design apparatus (a design apparatus 100 of Fig. 7 described later). Although details will be described later, this facilitates identification of the Tag using the learned model 300. Here, the conductor layer 12 and the elements 12E correspond to a specific example of the conductor of the present invention.

In each Tag, it is preferable that the plurality of elements 12E are arranged so as to have axes of rotational symmetry. That is, it is preferable that the design of each Tag is rotationally symmetric. Thus, the dependency on the polarization of the electromagnetic wave can be reduced. The plurality of elements 12E are arranged so as to have a four fold rotation axis in each Tag, for example. The plurality of elements 12E may be arranged so as to have a two fold rotation axis, a six fold rotation axis, or the like in each Tag.

The planar shape of the element 12E is, for example, a quadrangular shape such as a square. The planar shape of the element 12E is, for example, a square having a side length of 1 mm. By setting the planar shape of the element 12E to a quadrangular shape, the design of the Tag designed by the design apparatus is easily realized. The planar shape of the element 12E may be other shapes such as a circle, an ellipse, and a polygon.

In a case where the elements 12E each having a quadrangular shape are adjacent to each other at respective corners, the elements 12E are processed such that the elements 12E are not in contact with each other at the respective corners (refer to Fig. 3). The case where the elements 12E are adjacent to each other at the respective corners is, for example, a case where a plurality of elements 12E each having a quadrangular shape are arranged side by side in a diagonal direction of each other and are adjacent to each other only at the respective corners. In this case, the elements 12E have been subjected to, for example, processing to make them smaller in size than the other elements 12E, processing to round corners, or processing to remove corners. If the elements 12E are in contact with each other at the respective corners, a deviation between the electromagnetic wave spectrum obtained from the manufactured Tag and the electromagnetic wave spectrum of the Tag acquired by the design apparatus may increase, and the identification accuracy may decrease. Therefore, in the case where the elements 12E each having a quadrangular shape are adjacent to each other at the respective corners, the above-described processing is performed on the elements 12E, thus making it possible to suppress a decrease in the identification accuracy of the Tag.

The element 12E is formed of a conductor. The conductivity of the conductor forming the element 12E is, for example, 3.7 × 10⁷ S/m. The element 12E is made of, for example, a metallic material such as copper (Cu), silver (Ag), gold (Au), and aluminum (Al).

Fig. 5 illustrates another example of the cross-sectional configuration of the Tag. The Tag may have a conductor layer 13, the base material 11, and the conductor layer 12 in this order. That is, the conductor layer (conductor layer 12, 13) may be provided on both surfaces of the base material 11. The conductor layer 13 may be provided over the entire surface of the base material 11, or may be provided in a selective region of the base material 11.

### (Reader)

The reader 20 includes, for example, a transmitter 210, a receiver 220, and a controller 230 (Fig. 1). The reader 20 is arranged, for example, directly opposite to the Tag. The distance between the reader 20 and the Tag is, for example, several centimeters to several meters.

The transmitter 210 includes, for example, a transmission antenna and transmits an electromagnetic wave in a predetermined frequency band to a target T. The electromagnetic wave transmitted by the transmitter 210 is, for example, a sinusoidal electromagnetic wave having a peak intensity at a single frequency. The frequency band of the electromagnetic wave transmitted by the transmitter 210 changes according to time, for example. That is, the transmitter 210 transmits the electromagnetic wave by sweeping in a predetermined frequency band. The transmitter 210 may instantaneously transmit an electromagnetic wave having a predetermined intensity profile in a predetermined frequency band. That is, the transmitter 210 may transmit an electromagnetic wave in an impulse scheme.

The electromagnetic wave transmitted by the transmitter 210 is received by the receiver 220 after being reflected by the Tag, for example. The transmitter 210 may receive the electromagnetic wave that has passed through the Tag. The receiver 220 includes, for example, a reception antenna. The frequency band of the electromagnetic wave received by the receiver 220 is, for example, a high-frequency (HF) band, an ultra-high-frequency (UHF) band, an ultra-wideband (UWB) band (3.1 GHz to 10.6 GHz), a 24 GHz band, or a millimeter-wave band.

Based on the signal of the electromagnetic wave received by the receiver 220, the controller 230 detects the intensity, phase, or the like of the received electromagnetic wave, and generates an information item regarding the electromagnetic wave spectrum. The controller 230 is composed of, for example, a vector network analyzer.

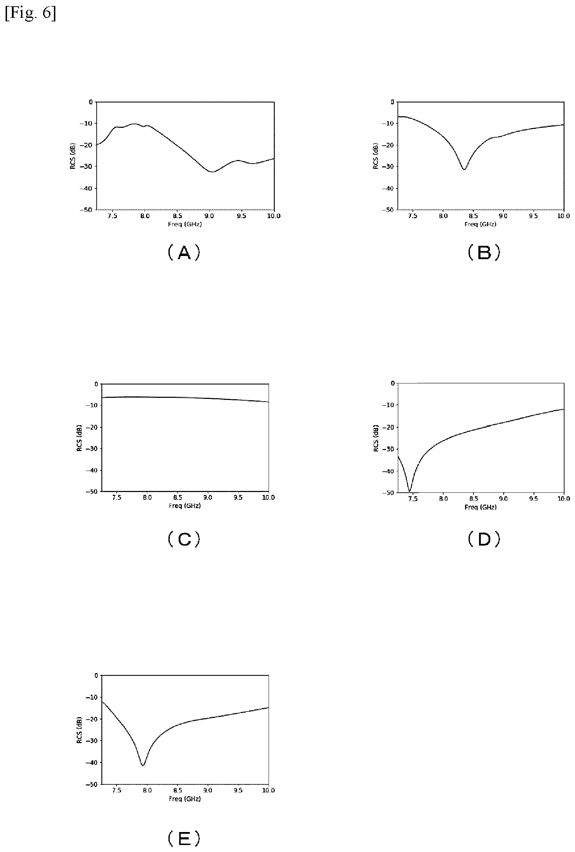

Figs. 6(A) to 6(E) illustrate examples of spectra of electromagnetic waves reflected from the TagA, the TagB, the TagC, the TagD, and the TagE, respectively. In Figs. 6(A) to 6(E), the horizontal axis represents frequency and the vertical axis represents intensity. As described above, each Tag of the tag group 10 has a corresponding one of spectrum information items on electromagnetic waves different from each other. The reader 20 may acquire the spectrum information item on the electromagnetic wave having passed through each Tag. Furthermore, the reader 20 may acquire a spectrum information item on an electromagnetic wave related to a phase of each Tag.

### (Identification apparatus)

The identification apparatus 30 uses the learned model 300 to analyze the spectrum information item on the electromagnetic wave acquired by the reader 20 and to identify to which one of the TagA, the TagB, the TagC, the TagD, and the TagE the spectrum information item on the electromagnetic wave corresponds.

The identification apparatus 30 is, for example, a computer such as a server or a PC. The identification apparatus 30 may include a plurality of devices and may be virtually configured as a cloud server by a large number of servers, for example. The identification apparatus 30 includes, for example, a central processing unit (CPU), a read only memory (ROM), a random access memory (RAM), a storage, a communication interface, and an operation display unit.

The CPU controls the above-described components and performs various kinds of arithmetic processing in accordance with programs recorded in the ROM or the storage.

The ROM stores various programs and various data.

The RAM temporarily stores programs and data as a work area.

The storage stores therein various programs including an operating system or various data. For example, an application for transmitting and receiving various information items to and from another apparatus and deciding analysis information item to be output based on various information items acquired from another apparatus is installed in the storage. Candidates of analysis information item to be output and information items necessary for deciding analysis information item to be output based on various information items are stored in the storage.

The communication interface is an interface for communicating with another apparatus. As the communication interface, communication interfaces based on various wired or wireless standards are used. For example, data communication is performed between the identification apparatus 30 and the reader 20 via the communication interface.

The operation display unit is, for example, a touch panel type display, displays various information items, and receives various kinds of input from a user.

The learned model 300 is stored in, for example, the storage. In the learned model 300, the spectrum information item on the electromagnetic wave of each Tag constituting the tag group 10 and the identification information item associated with each Tag are learned in advance as training data. When the spectrum information item on the electromagnetic wave acquired by the reader 20 is input to the learned model 300, the identification information item on the Tag (TagA, TagB, TagC, TagD, or TagE) read by the reader 20 is output. In the identification apparatus 30, for example, the information item regarding the output identification information item on the Tag is displayed on the operation display unit. The identification apparatus 30 may have a learning unit that causes the learned model 300 to learn a combination of the spectrum information item on the electromagnetic wave acquired by the reader 20 and a ground truth label of the identification information item on the Tag.

### [Design apparatus]

Next, a design apparatus for designing each Tag of the tag group 10 will be described.

Fig. 7 is a block diagram illustrating a schematic configuration of the design apparatus 100. The design apparatus 100 is, for example, a computer such as a server and a PC. The design apparatus 100 designs the optimized tag group 10 by, for example, an on/off method of topology optimization. The design apparatus 100 may include a plurality of devices and may be virtually configured as a cloud server by a large number of servers, for example.

As illustrated in Fig. 7, the design apparatus 100 includes a central processing unit (CPU) 110, a read only memory (ROM) 120, a random access memory (RAM) 130, a storage 140, a communication interface 150, and an operation display unit 160. The above-mentioned components are connected to each other through a bus 170 so as to be able to communicate with each other.

The CPU 110, the ROM 120, the RAM 130, the storage 140, and the communication interface 150 have the same functions as those of the corresponding components of the identification apparatus 30, and hence redundant description will be omitted.

Fig. 8 is a block diagram illustrating the functional configuration of the design apparatus 100.

The design apparatus 100 functions as, for example, a design unit 111, an acquisition unit 112, a calculation unit 113, a decision unit 114, a determination unit 115, and an output unit 116 when the CPU 110 reads a program stored in the storage 140 and executes processing.

The design unit 111 designs a plurality of tags. For example, the design unit 111 arranges the elements 12E on the base material 11 in a rotationally symmetric manner and designs 30 tags. The design unit 111 may randomly design a tag, or may design a tag according to a predetermined rule. The design unit 111 may design some of the plurality of tags according to a predetermined rule and may randomly design the rest of the plurality of tags.

The acquisition unit 112 acquires the spectrum information item on the electromagnetic wave of each of the plurality of tags designed by the design unit 111. For example, the acquisition unit 112 acquires an intensity information item reflected from each tag for each frequency of an electromagnetic wave by electromagnetic field simulation using a finite difference time domain (FDTD) method for each of the 30 tags designed by the design unit 111. The acquisition unit 112 may acquire a phase information item on each tag.

The calculation unit 113 calculates an objective function set for the spectrum information items on the electromagnetic waves acquired by the acquisition unit 112. The objective function is set to cause the identification apparatus 30 to identify each Tag of the tag group 10 with high accuracy. For example, the objective function is a sum of an average value and a minimum value of differences (hereinafter, referred to as differences d) between spectrum information items on electromagnetic waves of the plurality of tags acquired by the acquisition unit 112. By maximizing the objective function, the difference in spectrum between the tags becomes large, and the identification apparatus 30 easily identifies each Tag in the tag group 10. The objective function may be a minimum value of the differences d.

For example, first, the calculation unit 113 obtains the differences d in the frequency band 7.25 GHz to 10.25 GHz for all pairs of the 30 tags designed by the design unit 111. Next, the calculation unit 113 creates combinations of five tags from the 30 tags designed by the design unit 111, and obtains the sum of the average value of the differences d and the minimum value of the differences d for the five tags. Thus, an objective function is calculated. For example, the calculation unit 113 creates a combination of any five tags among the 30 tags and calculates the objective function.

The decision unit 114 decides a tag group including a predetermined number of tags, based on the objective function calculated by the calculation unit 113. For example, the decision unit 114 decides, as a tag group, a combination of five tags for which the objective function (e.g., the sum of the average value of the differences d and the minimum value of the differences d) calculated by the calculation unit 113 is maximized.

For example, the design unit 111 newly designs a plurality of tags based on each tag in the tag group decided by the decision unit 114. The design unit 111 newly designs the plurality of tags such that the arrangement of the elements 12E is optimized using, for example, an on/off method of topology optimization. For example, evolutionary computation (genetic algorithm) is used for the search for the tag design at this time. That is, in the design apparatus 100, a plurality of tags of the next generation are designed based on the designs of a plurality of tags of the previous generation, and the acquisition of the spectrum information items on the electromagnetic waves, the calculation of the objective function, and the decision of the tag group are sequentially performed again for the plurality of tags of the next generation.

The determination unit 115 determines whether the objective function has converged for the tag group of the next generation decided in this manner. The convergence of the objective function means a small change or no change between the objective function of the tag group selected in the previous generation and the objective function selected in the next generation. For example, the determination unit 115 determines that the objective function has converged in a case where the rate of change of the objective function is 10% or less over 100 generations. The determination unit 115 may determine that the objective function has converged in a case where the rate of change of the objective function is 5% or less or there is no change in the objective function over 100 generations. The determination unit 115 may determine the convergence of the objective function over less than 100 generations or more than 100 generations.

The output unit 116 outputs a tag group for which the determination unit 115 has determined that the objective function has converged. For example, the output unit 116 outputs the tag group by displaying the information item regarding the tag group on the operation display unit 160. The tag group (tag group 10) output by the output unit 116 is used in, for example, the management system 1.

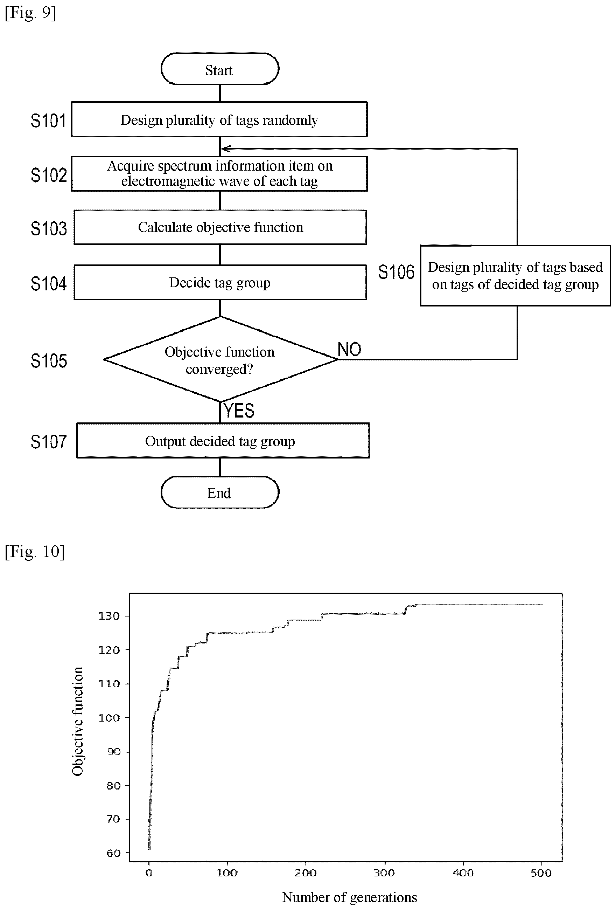

Fig. 9 is a flowchart illustrating a procedure of processing executed in the design apparatus 100. The processing of the design apparatus 100 illustrated in the flowchart of Fig. 9 is stored as a program in the storage 140 of the design apparatus 100, and is executed by the CPU 110 controlling each unit.

First, the design apparatus 100 designs a plurality of tags randomly (step S101). The plurality of tags designed in this step S101 constitute a plurality of tags of a first generation. The design apparatus 100 designs, for example, 30 tags of a first generation by arranging elements 12E in selective regions on the base material 11 in a rotationally symmetrical manner.

Next, the design apparatus 100 acquires a spectrum information item on an electromagnetic wave of each of the plurality of tags designed in step S101 (step S102). Subsequently, the design apparatus 100 calculates the objective function set for the spectrum information items on the electromagnetic waves acquired in step S102 (step S103). The objective function is, for example, a sum of an average value and a minimum value of the differences d.

Thereafter, the design apparatus 100 decides a tag group by combining a predetermined number of tags from among the plurality of tags designed in step S 101, based on the objective function calculated in step S103 (step S104). The design apparatus 100 combines, for example, five tags from among the 30 tags designed in step S101 such that the objective function is maximized. Thus, a tag group is decided.

Subsequently, the design apparatus 100 determines, for the tag group decided in step S104, whether the objective function has converged (step S105). For example, the design apparatus 100 determines that the objective function has converged in a case where there is no change in the objective function over 150 generations. When the design apparatus 100 determines that the objective function has converged for the tag group decided in step S104 (step S105: YES), the design apparatus 100 outputs an information item regarding the tag group (step S107), and ends the processing.

On the other hand, when the design apparatus 100 determines that the objective function has not converged for the tag group decided in step S104 (step S105: NO), the design apparatus 100 newly designs a plurality of tags based on the tags of this tag group (step S106). In step S106, for example, a plurality of tags of a second generation or later are designed using evolutionary computation. Details of step S106 will be described later.

After newly designing a plurality of tags (step S 106), the design apparatus 100 acquires a spectrum information item on an electromagnetic wave of each of the plurality of tags (step S102). Subsequently, the design apparatus 100 calculates the objective function set for the spectrum information items on the electromagnetic waves acquired in step S102 (step S103). The design apparatus 100 decides a tag group by combining a predetermined number of tags from among the plurality of tags designed in step S106, based on the objective function (step S104).

Thereafter, the design apparatus 100 determines, for the tag group decided in step S104, whether the objective function has converged (step S105). When the design apparatus 100 determines that the objective function has not converged (step S105: NO), the design apparatus 100 newly designs a plurality of tags (step S106). The design apparatus 100 repeats the processing from step S106 to step S105 until the objective function converges. Thus, a plurality of tags of the next generation are sequentially designed.

Fig. 10 illustrates a relationship between the number of generations of the tag designed in step S101 or step S106 and the value of the obj ective function calculated in step S103. As described above, in the design apparatus 100, as the number of generations of the tag increases, the rate of change of the objective function decreases. For example, in Fig. 10, the objective function does not change from around the three hundred fiftieth generation to the five hundredth generation. At this time, the design apparatus 100 outputs an information item regarding a tag group (e.g., the tag group 10) decided from the plurality of tags of the five hundredth generation (step S107), and ends the processing.

The tags (e.g., TagA to TagE in Figs. 2(A) to 2(E)) of the tag group output in step S107 are used for the management system 1.

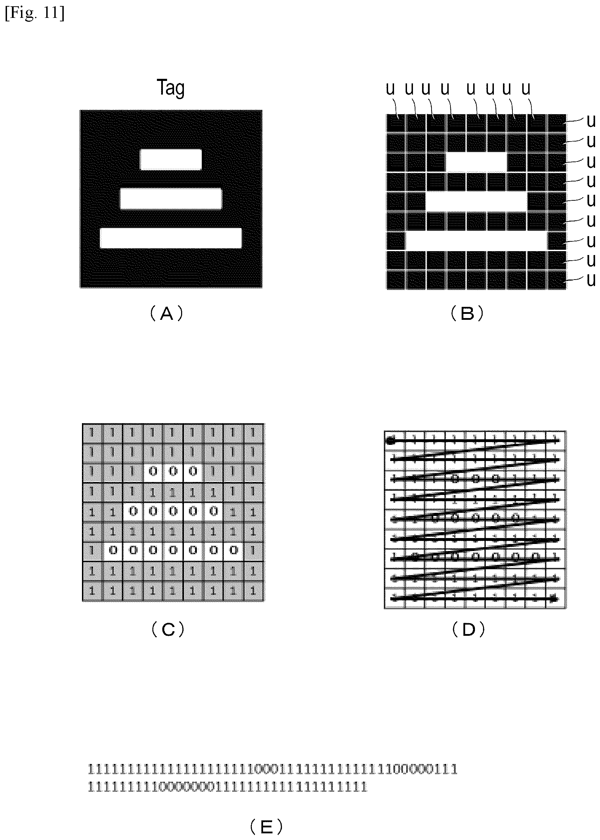

Here, the processing of step S106 will be described with reference to Figs. 11(A) to 11(E). Figs. 11(A) to 11(E) each illustrate an example of a method for designing a new Tag using an on/off method of topology optimization and evolutionary computation.

First, the tag (Fig. 11(A)) of the tag group decided in step S 104 is divided into a plurality of unit regions u (Fig. 11(B)). The unit regions u have, for example, a quadrangular planar shape and are arranged in a matrix. The unit region u has, for example, a square planar shape, and the planar shape of the unit region u is the same as the planar shape of the element 12E. Alternatively, the planar shape of the unit region u and the planar shape of the element 12E are in a similar relationship.

Next, each of the plurality of unit regions u is binarized. For example, "0" is allocated to the unit region u in which the element 12E formed of the conductor is arranged, and "1" is allocated to the unit region u in which the element 12E is not arranged (Fig. 11(C)).

Next, "0" and "1" individually allocated to the plurality of unit regions u are made one dimensional (Fig. 11(D)). Specifically, "0" and "1" in a matrix are arranged one dimensionally along a predetermined order. Thus, the gene of the tag (Fig. 11(E)) is formed.

Subsequently, genes of new tags are formed by performing crossover or mutation on the gene of the tag. The tags designed in step S106 include, for example, tags formed from the genes of the new tags. The genes of the new tags may be formed from the genes of all (e.g., five) or some of tags of the tag group decided in step S104.

For example, the design apparatus 100 designs 30 tags in step S106. Out of the 30 tags, 20 tags are designed by genetic crossover or mutation as described above, 5 tags are designed to have the same design as the tags of the tag group decided in step S104, and 5 tags are designed randomly.

### [Operations and effects of management system]

As described above, the tag group 10 of the management system 1 of the present embodiment is designed by the design apparatus 100. Therefore, in the tag group 10, the objective function set for the spectrum information items on the electromagnetic waves has converged on the TagA, the TagB, the TagC, the TagD, and the TagE. This facilitates identification of the Tag using the learned model 300. Hereinafter, the operations and effects will be described.

As a method of identifying the tag, it is conceivable to use a position and the number of peaks in a spectrum of an electromagnetic wave obtained from the tag. However, with this method, since there are few variations in positions, the number, and the like of peaks, it is difficult to increase the number of identifiable tags. On the other hand, for example, by using the AI technology, it is possible to use the shape of the entire spectrum of the electromagnetic wave for identification of the tag without depending only on the peak.

When a person himself/herself designs a tag by thinking, the design tends to be simple. Therefore, even in the case of tags having different designs, there is a concern that the spectral shapes of the obtained electromagnetic waves may be similar. That is, even in a case where the AI technology is used, there is a concern that the tag cannot be identified with sufficient accuracy.

On the other hand, the tag group 10 of the present embodiment is designed by the design apparatus 100, and the objective function set for the spectrum information items on the electromagnetic waves has converged in the Tags of the tag group 10. In other words, the design apparatus 100 can optimize the design of each Tag such that the spectral shape of the electromagnetic wave of each Tag of the tag group 10 is identified with sufficient accuracy by the identification apparatus 30 (learned model 300). Therefore, the management system 1 can identify each Tag with high robustness.

Note that such optimization is not performed for a plurality of tags designed by human thinking. Accordingly, in a case where optimization such as topology optimization is performed for a plurality of tags designed by human thinking, the objective function significantly changes (e.g., a change in the objective function between the first generation and the second generation in Fig. 10, and the like).

As described above, in the management system 1 of the present embodiment, the objective function set for the spectrum information items on the electromagnetic waves has converged in the Tags included in the tag group 10. This facilitates identification of the Tag using AI. Therefore, the management system 1 can be suitably used for identification of the Tag using AI (e.g., learned model 300).

In addition, in the management system 1, an IC chip or the like is not necessary for identification of the Tag, and it is possible to suppress cost. Therefore, the management system 1 can be suitably used for management of a large number of articles and the like.

Furthermore, the identification apparatus 30 of the management system 1 identifies each Tag of the tag group 10 using the learned model 300. Thus, the identification apparatus 30 can identify a spectrum having a more complicated shape. That is, each Tag can be easily identified using the shape of the entire spectrum of the electromagnetic wave obtained from each Tag without depending on only the peak. Therefore, in the management system 1, it is possible to easily increase the number of identifiable Tags.

In addition, by using the design apparatus 100, each Tag constituting the tag group 10 can be easily designed.

In addition, the design apparatus 100 preferably optimizes the design of each Tag of the tag group 10 using an on/off method of topology optimization. Thus, the degree of freedom in optimization increases, and it is possible to improve accuracy in identification of a Tag.

Furthermore, it is preferable that the design apparatus 100 searches for the design of the Tag using evolutionary computation, thereby achieving a convergence of the objective function. Thus, it is possible to efficiently search for the design of the Tag, and it is possible to improve the identification accuracy of the Tag.

The configurations of the management system 1 and the design apparatus 100 described above are the main configurations in describing the features of the above-described embodiment, and the present invention is not limited to the above-described configurations and can be variously modified within the scope of the claims. Furthermore, configurations included in a general management system are not excluded.

For example, in the above-described embodiment, the example in which each Tag of the tag group 10 has the laminated structure of the base material 11 and the conductor layer 12 has been described, but each Tag is only required to have at least the conductor layer 12.

In the above-described embodiment, the example in which the tag group 10 includes five Tags has been described, but the tag group 10 is only required to include a plurality of Tags. For example, the tag group 10 may include four or less Tags, or may include six or more Tags.

Furthermore, in the above-described embodiment, the example in which the tag group 10 is used for article management has been described, but the tag group 10 may be used for applications other than article management. For example, the tag group 10 may be used as a sensor. In this sensor, for example, the fact that the spectrum information item on the electromagnetic wave of the Tag changes due to a change in the surrounding environment is utilized. Specifically, the state of the base material changes due to a change in ambient moisture content, temperature, or the like, and the spectrum information item on the electromagnetic wave of the Tag changes. At this time, in the learned model, for example, spectrum information items on electromagnetic waves of the Tags measured in different environments and respective environment information items associated with the environments are used as training data. By using such a learned model, it is possible to sense the moisture content, temperature, and the like of the environment in which the Tag is placed.

In addition, in the above-described embodiment, the example in which the objective function is set to the sum of the average value and the minimum value of the differences d has been described, but the objective function may be set to another value of the spectrum information item on the electromagnetic wave.

In addition, in the above-described embodiment, the example in which the element 12E has a quadrangular planar shape has been described, but the planar shape of the element 12E may be any other shape.

In addition, in the above-described embodiment, the example in which the base material 11 is provided on the entire surface of each Tag and the element 12E is arranged in the selective regions on the base material 11 has been described, but a conductive film may be provided on the entire surface of each Tag and an opening or a dielectric may be provided in selective regions on the conductive film.

Furthermore, in the above-described embodiment, the example in which the design apparatus 100 optimizes the design of a tag by using the on/off method of topology optimization has been described, but the design apparatus 100 may optimize the design of a tag by using another method. The design apparatus 100 may use a level set method of topology optimization or may use a parameter optimization method.

In addition, in the above-described embodiment, the example in which the design apparatus 100 searches for the design of the tag using the evolutionary computation has been described, but the design apparatus 100 may search for the design of the tag using another method.

In addition, each of the reader 20, the identification apparatus 30, and the design apparatus 100 may include a plurality of devices or may be configured as a single apparatus.

The function of each component may be implemented by another component. For example, the reader 20 may be integrated with the identification apparatus 30, and some or all of the functions of the reader 20 may be implemented by the identification apparatus 30.

In addition, in the above-described embodiment, the example in which the identification apparatus 30 identifies the Tag using the learned model 300 has been described, but the identification apparatus 30 may identify the Tag by another method such as statistical processing.

In addition, some steps of the above-described flowchart may be omitted, and other steps may be added. Furthermore, some of the steps may be executed at the same time, and one step may be divided into a plurality of steps and executed.

Furthermore, the means and method for performing various kinds of processing in the design apparatus 100 described above can be implemented by either a dedicated hardware circuit or a programmed computer. The program may be provided by a computer-readable recording medium such as a USB memory or a digital versatile disc (DVD)-ROM, or may be provided online via a network such as the Internet. In this case, the program recorded on the computer-readable recording medium is generally transferred to and stored in a storage unit such as a hard disk. Furthermore, the program may be provided as a single piece of application software, or may be incorporated, as a function, into software of an apparatus such as the detection unit.

This application is based on Japanese Patent Application (Japanese Patent Application No. 2020-212376) filed on December 22, 2020, the disclosure of which is incorporated herein by reference in its entirety.

### Reference Signs List

- 1: management system
- 10: tag group
- 11: base material
- 12, 13: conductor layer
- 20: reader
- 210: transmitter
- 220: receiver
- 230: controller
- 30: analysis apparatus
- 300: learned model
- 100: design apparatus
- 110: CPU
- 120: ROM
- 130: RAM
- 140: storage
- 150: communication interface
- 160: operation display unit
- Tag: tag

## Claims

1. A tag group comprising a plurality of tags each having a conductor arranged in a selective region thereof and having a corresponding one of spectrum information items on electromagnetic waves different from each other,
wherein an objective function set for the spectrum information items on the electromagnetic waves has converged in the plurality of tags included in the tag group.

2. The tag group according to claim 1, wherein the objective function has converged by optimizing arrangement of the conductors by an on/off method of topology optimization.

3. The tag group according to claim 1 or 2, wherein the objective function has converged by being searched for using evolutionary computation.

4. The tag group according to any one of claims 1 to 3, wherein the objective function is a sum of an average value and a minimum value of differences between the spectrum information items on the electromagnetic waves of the plurality of tags.

5. The tag group according to any one of claims 1 to 4, wherein the conductor of each of the plurality of tags is arranged so as to have an axis of rotational symmetry.

6. The tag group according to any one of claims 1 to 5, wherein the conductor of each of the plurality of tags is constituted by a combination of a plurality of quadrangular conductors.

7. The tag group according to claim 6, wherein the plurality of quadrangular conductors are processed such that the plurality of quadrangular conductors are not in contact with each other at respective corners.

8. The tag group according to any one of claims 1 to 7, wherein each of the plurality of tags includes the conductor and a dielectric.

9. The tag group according to any one of claims 1 to 8, wherein the spectrum information items on the electromagnetic waves are spectrum information items on electromagnetic waves reflected from the plurality of tags or spectrum information items on electromagnetic waves having passed through the plurality of tags.

10. A design apparatus comprising:
a design unit that designs a plurality of tags each having a conductor arranged in a selective region thereof;
an acquisition unit that acquires a spectrum information item on an electromagnetic wave of each of the plurality of tags designed by the design unit; and
a decision unit that decides a tag group including a predetermined number of tags from among the plurality of tags, based on an objective function set for the spectrum information items on the electromagnetic waves acquired by the acquisition unit.

11. The design apparatus according to claim 10, further comprising:
a determination unit that determines whether the objective function has converged for the tag group decided by the decision unit; and
an output unit that outputs the tag group for which the determination unit has determined that the objective function has converged.

12. A design method comprising:
designing a plurality of tags each having a conductor arranged in a selective region thereof;
acquiring a spectrum information item on an electromagnetic wave of each of the plurality of tags; and
deciding a tag group including a predetermined number of tags from among the plurality of tags, based on an objective function set for the spectrum information items on the electromagnetic waves.

13. A learned model that has been machine-learned in advance using, as training data, a spectrum information item on an electromagnetic wave of each of a plurality of tags constituting a tag group and an identification information item associated with each of the plurality of tags,
wherein an objective function set for the spectrum information items on the electromagnetic waves has converged in the plurality of tags included in the tag group.

14. An identification apparatus that identifies a predetermined tag by inputting a spectrum information item on an electromagnetic wave of the predetermined tag into the learned model according to claim 13.
